# EUROPÄISCHE PATENTSCHRIFT

(11) **EP 2 104 410 B1**
(45) Veröffentlichungstag und Bekanntmachung des Hinweises auf die Patenterteilung: **19.12.2012**
(21) Anmeldenummer: 09003795.3
(22) Anmeldetag: 17.03.2009
(51) Int. Cl.: H05K 7/20

(54) **Geräteaufbau**
Device construction
Montage d'appareil

(30) Priorität: 19.03.2008 DE 202008003872 U
(43) Veröffentlichungstag der Anmeldung: 23.09.2009
(73) Patentinhaber: Doswald, Jörg A., 6353 Weggis (CH)
(72) Erfinder: Doswald, Jörg A., 6353 Weggis (CH)
(74) Vertreter: Ebert, Jutta

(56) Entgegenhaltungen:
- US-A- 5 986 887
- US-A1- 2002 122 296
- US-A1- 2004 085 728

## Beschreibung

Die Erfindung bezieht sich auf einen Geräteaufbau, bei dem ein Gehäuse mehrere elektronische Bauelemente, Bausätze, Baueinheiten mit ihren Trägerplatten geschichtet aufnimmt und im oder am Gehäuse ein Lüfter vorgesehen ist, mit dessen Hilfe Luft zur Kühlung der Bauelemente durch das Gehäuse geleitet werden kann, und bei dem zwischen zwei elektronischen Baueinheiten ein Kühlblock aus wärmeleitendem Material vorgesehen ist

Durch das Bestreben, elektronische Geräte immer kleiner, leichter und raumsparender zu gestalten und auch die Montage zeitsparender zu machen, enthalten diese heutzutage in einem Gehäuse Bausätze und Baueinheiten, die auf einem Träger oder einer Grundplatte einzelne oder Gruppen von Bauelementen in immer kleinerer, minimalisierter Ausführung und in räumlich immer gedrängterer Anordnung aufweisen. Die Bausätze und Baueinheiten sind dabei ihrerseits auf Trägerplatten und über diese am Gehäuse, häufig auch steckbar, befestigt. Die dichte Anordnung der Elemente auf möglichst kleinem Raum, führt zu Problemen bei der Wärmeentwicklung, durch die Schäden an den Bauelementen und Baueinheiten entstehen können, die bis zum Ausfall und sogar Zerstörung eines Gerätes führen können. Es müssen deshalb Mittel zur Kühlung und Wärmeableitung bzw. allgemein zur Temperaturkontrolle vorgesehen werden. Außerdem werden immer höhere Anforderungen gestellt, um bestimmte elektronische Geräte bei unterschiedlichen, wechselnden und auch extremen Umweltbedingungen einsetzbar zu machen. Von besonderer Bedeutung ist dies bei Geräten, die im Outdoor-Bereich z.B. der IT-Branche zum Einsatz kommen, z.B. Server, Access Point, Wireless Outdoor Router und andere. Bei solchen Geräten besteht die Forderung, dass sie nicht nur korrosionsfest und wasserdicht sondern auch bei Temperaturen von -33°C bis über +40°C zuverlässig einsetzbar sein müssen. Bausätze oder Baueinheiten sollen außerdem, z.B. im Falle einer doch auftretenden Störung, leicht und schnell austauschbar sein.

Es ist bekannt, zur Kühlung der inneren Bauelemente eines Geräts mit einem Ventilator oder Lüfter Luft durch das Gerät hindurchzuleiten und / oder sein Gehäuse mit Kühlrippen zu versehen, um die Wärme ableitende Oberfläche zu vergrößern. Dies hat sich bei im Outdoor-Bereich unter starken Temperaturschwankungen einzusetzenden Geräten als nicht ausreichend erwiesen. Es hat sich vielmehr gezeigt, dass einerseits eine zusätzliche Kühlung im oberen Temperaturbereich aber andererseits auch Wärmezufuhr im unteren Temperaturbereich erforderlich ist.

Träger- oder Grundplatten, auf denen die Bausätze und Baueinheiten mit ihren Trägerplatten befestigt sind, sind bei bekannten Geräten starr mit dem Gehäuse verbunden, z.B. verschraubt. Wenn die Geräte starken Temperaturschwankungen ausgesetzt sind, treten durch Materialausdehnung und deren Rückbildung erhebliche thermomechanische Kräfte auf, die bei bekannten Geräten zu Schäden, z.B. der Bindung von Haarrissen an den Trägerplatten und den anderen Elementen, und schließlich sogar zum Ausfall eines Gerätes führen können, denn die durch Schrauben starr miteinander verbundenen Teile können diesen Kräften nicht nachgeben, sie nicht ausgleichen.

Durch die US 5,986,887 ist ein Geräteaufbau bekannt, bei dem Schalt- oder Trägerplatten, auf denen elektronische Bauelemente befestigt sind, in gleicher Ausrichtung übereinander gestapelt angeordnet sind und dabei durch beidseitig angeordnete Anschlussleisten, die sich über die gesamte Länge der Trägerplatten erstrecken, auf Abstand gehalten werden. Zwischen den Trägerplatten und auf der obersten Trägerplatte ist mittig, jeweils ein langgestreckter, wärmeleitender Kühlblock angeordnet; diese wärmeleitenden Kühlblöcke stehen in engem Kontakt mit den Trägerplatten. Die Anzahl der wärmeleitenden Kühlblöcke entspricht der Anzahl der Trägerplatten. Auf dem obersten wärmeleitenden Kühlblock befindet sich eine mit Kühlrippen versehene Kühleinheit, auch Wärmesenke genannt Zusammengehalten wird das Ganze mittels Schrauben, die durch den gesamten Stapel, d.h. durch die Wärmesenke, durch die Trägerplatten und die auf ihnen angebrachten wärmeleitenden Kühlblöcke und eine zuunterst angeordnete Trägerleiste hindurchgehen. Für den Wärmetransport von den elektronischen Baueinheiten nach außen sind wärmeleitende Verbindungen zwischen den elektronischen Baueinheiten und wärmeleitenden Schichten, die sich innerhalb der Trägerplatten befinden, vorgesehen; die wärmeleitenden Schichten wiederum haben Verbindung zu den wärmeleitenden Kühlblöcken, und über die wärmeleitenden Schichten in den Trägerplatten ist außerdem eine Verbindung zwischen den wärmeleitenden Kühlblöcken untereinander hergestellt. Die in den elektronischen Baueinheiten entstehende Wärme wird also zunächst über wärmeleitende Verbindungen in die jeweilige Trägerplatte und zu der darin befindlichen wärmeleitenden Schicht und von dort zu den wärmeleitenden Kühlblöcken geleitet. Die wärmeleitenden Kühlblöcke stehen untereinander in Verbindung, so dass die Wärme schließlich auf die auf dem obersten wärmeleitenden Block aufliegende Kühleinheit (Wärmesenke) übergehen kann. Der Wärmetransport vollzieht sich hier also auf einem relativ langen Weg. Es müssen für diese Anordnung spezielle Trägerplatten hergestellt werden, in die die erwähnte wärmeleitende Schicht eingebettet sein muss. Auch die Verbindung der einzelnen wärmeleitenden Teile zu einem wärmeleitenden Pfad erfordert besondere Maßnahmen. Damit erhöhen sich die Kosten bei der Herstellung. Ein Luftstrom, der zur Kühlung beitragen könnte wird durch die seitlich zwischen den Trägerplatten angeordneten Anschlussleisten behindert- Der Zusammenhalt des Aufbaus mittels durch alle Schichten der Bauelemente hindurchgehender Schrauben erfordert präzise Montagearbeit und erschwert die Arbeit in Fällen, in denen bei einer auftretenden Störung z.B. Bausätze oder Baueinheiten ausgetauscht werden müssen. Wegen der starren Verbindung der Bauelemente mittels Schrauben, können bei Temperaturschwankungen auftretende thermodynamische Kräfte zu Beschädigungen, z.B. zu Haarrissen an den Trägerplatten und anderen Bauteilen führen. Diese Art eines Geräteaufbaus ist auch nur in einem begrenzten Temperaturbereich und jedenfalls nicht bei sehr niedrigen Temperaturen einsetzbar, wenn statt einer Kühlung die Zufuhr von Wärme notwendig wird, um ein Gerät funktionsfähig zu halten.

Durch die US 2004/0085728 A1 ist ein Gehäuseaufbau bekannt, bei dem die Gehäusewand mit mehreren Öffnungen versehen ist, in die mit Kühlrippen versehene Kühlvorrichtungen (Wärmesenken) jeweils mit Hilfe eines Verbindungsstücks eingesetzt werden können. Die Verbindungsstücke stellen auch eine direkte Verbindung zwischen den Wärmesenken und Steckvorrichtungen zur Aufnahme elektronischer Karten her. Die elektronischen Karten werden mechanisch in engem Kontakt mit ihren Steckvorrichtungen gehalten, so dass an den elektronischen Karten entstehende Wärme direkt von jeder Steckvorrichtung über das Verbindungsstück zur jeweiligen Wärmesenke abgeleitet wird. Wie bereits erwähnt, hat es sich gezeigt, dass beim Einsatz von Geräten im Outdoor-Bereich und unter extremen äußerten Bedingungen, wie starken Temperaturschwankungen, solche mit Kühlrippen versehene Wärmesenken nicht ausreichend sind, um die in einem Gerät entstehende Wärme wie erforderlich abführen zu können. Eine Möglichkeit, beim Einsatz von Geräten unter extrem niedrigen Temperaturen dem Gerät Wärme zuführen zu können, ist nicht gegeben.

Aufgabe der Erfindung ist es, den Geräteaufbau ausgehend von standardmäßig erhältlichen Gehäusen und kommerziell erhältlichen, elektronischen Baugruppen so zu gestalten und zu verbessern, dass die Geräte absolut wasserdicht und gegen hohe Temperaturschwankungen und die dabei auch zyklisch auftretenden, thermomechanischen Kräfte geschützt sind, um sie insbesondere im Outdoor-Bereich und in einem dabei geforderten, aus Sicherheitsgründen noch weiter erhöhten Temperaturbereich von -40°C bis +70°C funktionsfähig zu halten. Die Anordnung der Baugruppen soll dabei auch weiterhin möglichst raumsparend und die Montage unkompliziert und zeitsparend sein. Auch Erschütterungen unterschiedlicher Art müssen die Geräte standhalten. Für die für den Einsatz notwendige Zertifizierung müssen sie den folgenden Normen und Prüfungen genügen:
- EMV Prüfung nach ETSI 300328
- EMV Prüfung nach ETSI 301489-1
- EMV Prüfung nach ETSI 301489-17
- EMV Prüfung nach EN 61000-3-3
- CE Konformitätsprüfung nach EN 60950-1
- Schutzklasse 2
- CE Konformitätsprüfung nach EN 60950-22
- IP65 Prüfung (Wasserdichtigkeit) nach EN 60529
- Umweltprüfung nach EN 60068-2-1 24h bei -25°C im Betrieb
- Umweltprüfung nach EN 60068-2-2 72h bei +60°C im Betrieb
- Umweltprüfung nach EN 60068-2-78 40°C bei 93% relativer Feuchtigkeit, 4 Zyklen ä 24h im Betrieb
- Umweltprüfung nach EN 60068-2-2 2h bei 70°C, (Temperaturschutzschaltung deaktiviert)
- Sinusschwingungen nach EN 60068-2-6
- Schockprüfung nach EN 60068-2-27
- Dauerschock nach EN 60068-2-29

Dies wird erfindungsgemäß erreicht durch einen Geräteaufbau gemäß Anspruch 1.

Die elektronischen Bauelemente, Bausätze, Baueinheiten mit ihren Trägerplatten und weitere Zusatzbauelemente sind nach der Erfindung auf einer im Gehäuse verschiebbaren Grundplatte geschichtet angeordnet; in dem geschichteten Aufbau ist zwischen jeweils zwei elektronischen Baueinheiten ein Kühlblock aus wärmeleitendem Material vorgesehen, und die Grundplatte wird allein durch die Kraft von Federn im Gehäuse so positioniert und in dieser Position gehalten, dass der geschichtete Aufbau ganz oder teilweise in Berührung steht mit der Innenseite einer benachbarten Gehäusewand. Indem der geschichtete Aufbau bzw. der zwischen elektronischen Baueinheiten angeordnete Kühlblock mit der Gehäusewand in Berührung gehalten wird, kann der Kühlblock Wärme aus seiner Umgebung aufnehmen und an das Gehäuse und schließlich an die Umgebungsluft abgeben. Indem die Grundplatte samt Aufbau im Gehäuse nur durch die Kraft von Federn positioniert wird, können auftretende Wärmeausdehnungen und deren Rückbildungen durch diese Federn ausgeglichen und damit Schäden im Gerät vermieden werden. Auch Stöße und Erschütterungen werden über die Federn aufgefangen. Die besondere Art der Halterung der Grundplatte im Gehäuse erleichtert auch die Montage und die Reparatur im Falle einer doch auftretenden Störung; das Lösen und/oder Festziehen von Schrauben entfällt.

Nach einer Ausführungsform der Erfindung ist auf der Grundplatte eine erste elektronische Baueinheit (Router) mit ihrer Trägerplatte lösbar befestigt, der Kühlblock ist auf einem dafür vorgesehenen Feld der ersten elektronischen Baueinheit aufgesetzt und gehalten, und die nächste (zweite) elektronische Baueinheit (Modem) ist, mit ihrer Trägerplatte vom Kühlblock wegweisend, auf dem Kühlblock aufliegend an diesem lösbar befestigt; die Elemente dieses Aufbaus werden durch die Kraft einer V-förmig gebogenen Blattfeder, die sich mit ihren Schenkeln auf der Trägerplatte der obersten elektronischen Baueinheit abstützt und durch einen das Gerät verschließenden Deckel gespannt wird, indem dieser mit der Spitze der Feder Druck ausübend in Berührung kommt, als Paket zusammen gehalten. Durch die Fixierung des geschichteten Aufbaus als Paket durch Federkraft auf der Grundplatte wird auch in dieser Richtung ein Ausgleich von Wärmeausdehnung und deren Rückbildung ermöglicht.

Der Kühlblock kann vorzugsweise aus Aluminium bestehen und auf seiner Ober- und seiner Unterseite mit jeweils einer Polsterschicht (GapPad) aus einem flexiblen, wärmeleitfähigen und elektrisch isolierenden Material versehen sein, wobei diese Polsterschichten (GapPads) die Auflageflächen für die elektronischen Baueinheiten bilden. Auch durch diese Polsterschichten können Wärmeausdehnungen und deren Rückbildung, sowie Ungleichmäßigkeiten an den Bauteilen ausgeglichen werden.

Vorzugsweise sind die erste elektronische Baueinheit (Router) an der Grundplatte und die zweite elektronische Baueinheit (Modem) am Kühlblock mittels steckbarer Haltebolzen lösbar befestigt sind. Diese Art der Befestigung erleichtert die Montage, und die Haltebolzen gewährleisten einen Mindestabstand zwischen Teilen der Bauelemente, was für die Kühlung und Wärmeabfuhr von Vorteil ist.

Es ist vorteilhaft, wenn der geschichtete Aufbau an der einen Längskante der Grundplatte übersteht und hier in Berührung kommt mit der Innenseite der benachbarten Gehäusewand, oder wenn nur der Kühlblock an der einen Längskante der Grundplatte übersteht und in Berührung kommt mit der Innenseite der benachbarten Gehäusewand. Durch diesen Kontakt kann vom Kühlblock aufgenommene Wärme zügig an die Gehäusewand abgegeben werden, von wo sie in die Umgebung abstrahlt.

An der Stelle, wo der geschichtete Aufbau oder der Kühlblock in Berührung steht mit der Innenseite der benachbarten Gehäusewand, kann vorteilhaft eine weitere Polsterschicht (GapPad) aus flexiblem, wärmeleitfähigem, elektrisch isolierendem Material vorgesehen sein, die hilft, die Wärmeableitung zu beschleunigen und Wärmeausdehnungen auszugleichen.

Der geschichtete Aufbau ist an der einen Längskante der Grundplatte bevorzugt mittig angeordnet, so dass der Aufbau auch von durch den Lüfter zugeführter Kühlluft bestrichen werden kann.

An der Außenseite der Gehäusewand, mit deren Innenseite der geschichtete Aufbau oder der Kühlblock in Berührung steht, kann ein äußerer Kühlkörper vorgesehen sein, durch den die Wärmeabstrahlung noch verbessert wird.

Nach einer bevorzugten Ausführungsform der Erfindung sind an der dem geschichteten Aufbau abgewandten Kante der Grundplatte Winkel angeordnet, die der dem geschichteten Aufbau abgewandten Gehäusewand gegenüberstehen; durch die Kraft von V-förmig gebogenen Blattfedern, die sich einerseits an dieser Gehäusewand und andererseits an den Winkeln abstützen, wird dann die Grundplatte samt Aufbau im Gehäuse derart in Position geschoben und gehalten, dass der geschichtete Aufbau in Berührung steht mit der ihm benachbarten Gehäusewand.

Da der Temperaturbereich, in dem die Geräte einsetzbar sein sollen, sowohl sehr hohe als auch sehr niedrige Temperaturen umfasst, kann einmal Wärmeableitung, ein anderes Mal Wärmezufuhr notwendig sein. Deshalb kann vorteilhaft an der Innenseite der Gehäusewand, mit der der geschichtete Aufbau in Berührung steht, eine Heizfolie vorgesehen sein; die Heizfolie und der Lüfter können dann über eine Temperaturkontrolleinheit mit Temperaturfühler temperaturabhängig gesteuert ein- und ausgeschaltet werden.

Die Betriebsposition des Gerätes ist bevorzugt hochvertikal stehend, wobei an der oberen Schmalseite des Gehäuses eine Temperaturkontrolleinheit mit Temperaturfühler angeordnet ist. In dieser Position beansprucht das Gerät nicht nur eine geringere Montagefläche; die aufsteigende, warme Luft staut sich hier unter der oberen Schmalseite des Gehäuses und nicht großflächig über der Elektronik, die sich bevorzugt im mittleren Bereich des Gehäuses befindet. Hier, wo sich ansteigenden Temperaturen am ehesten bemerkbar machen, ist dann auch die Temperaturkontrolleinheit mit Temperaturfühler untergebracht.

Die Erfindung wird im Folgenden anhand der anhängenden Zeichnung am Beispiel eines Outdoor Routers näher beschrieben; es zeigen
- Fig. 1: die Explosionszeichnung eines Outdoor Routers nach der Erfindung,
- Fig. 2: die Draufsicht auf einen geöffneten Outdoor Router nach Fig. 1 und
- Fig. 3: eine perspektivische Ansicht des Outdoor Routers nach Fig. 1 und 2 in geöffnetem Zustand, d.h. ohne Deckel.

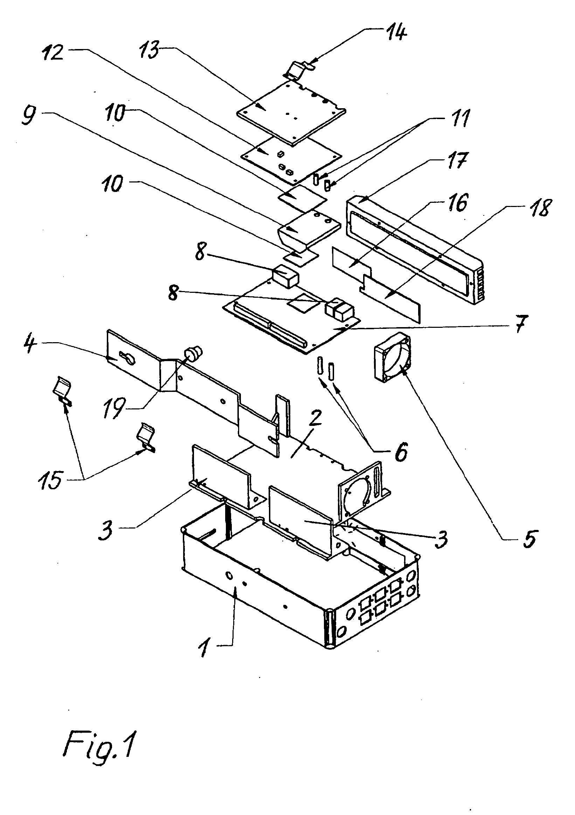

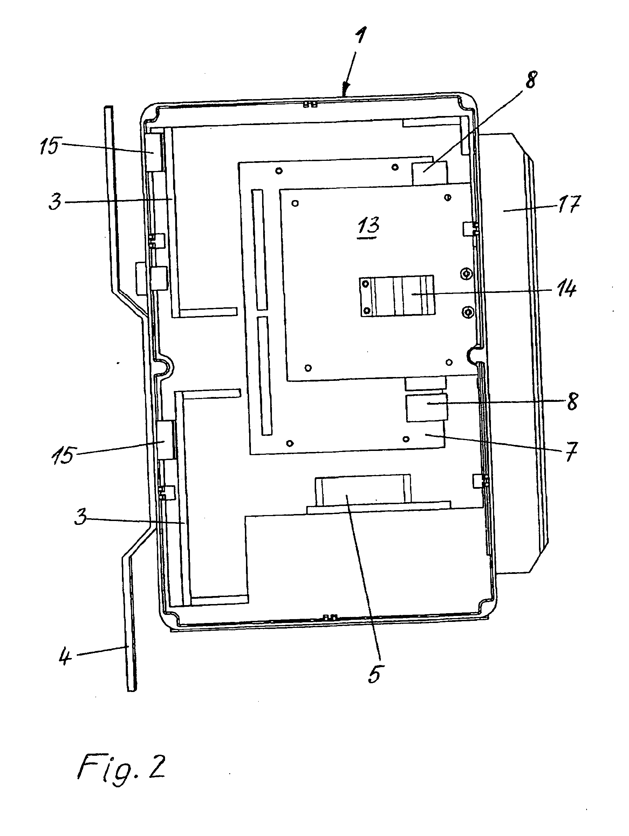

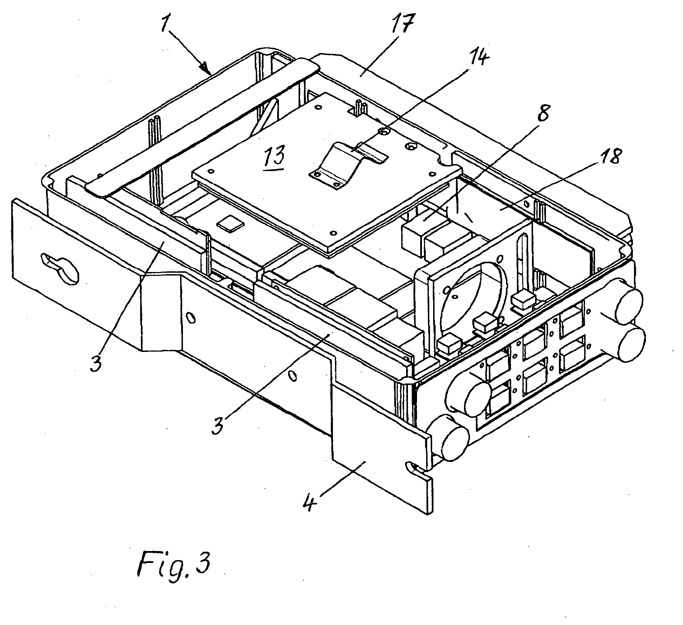

Gemäß Fig. 1 wird im Gehäuse 1, das vorzugsweise aus einem dünnwandigen, kostengünstigen Aluminiumdruckguss bestehen kann und hier eine rechteckige Form aufweist, eine Grundplatte 2 als Träger für weitere Baugruppen und Baueinheiten im Gehäuse verschiebbar, d.h. mit Spiel zur Gehäusewand, platziert. An der einen Längsseite der Grundplatte 2 sind Winkel 3 angeordnet, die, wie weiter unten noch erläutert wird, in einer besonderen, erfindungsgemäßen Weise der Halterung und genauen Positionierung der Grundplatte 2 mit darauf angeordneten Bauelementen und Baugruppen im Gehäuse 1 dienen. Außen an der Gehäusewand kann bei Bedarf eine Halterung 4, z.B. in Form eines winklig abgebogenen Halteblechs 4 mit Halteöse, angebracht sein. An der einen Schmalseite der Grundplatte 2 ist rechtwinklig hochstehend eine Halterung für einen Lüfter 5 vorgesehen, der in bekannter Weise Luft durch das Gerät blasen kann. Mit Hilfe eines ersten Satzes von steckbaren Haltebolzen 6, nach Fig. 1 sind es zwei Haltebolzen 6, wird auf der Grundplatte 2 als erste elektronische Baueinheit 7 der Router 7 derart platziert, dass er an der von den Winkeln 3 abgewandten Kante der Grundplatte 2 entweder leicht übersteht oder mit ihr abschließt. Dabei garantieren die Haltebolzen 6 auch einen erwünschten Abstand zwischen Router 7 und Grundplatte 2, so dass vom Lüfter 5 eingeblasene Luft kühlend hindurchstreichen kann. Auf einem dafür vorgesehenen Feld des Routers 7 wird zwischen Halteblöcken 8 ein Kühlkörper 9 oder Kühlblock 9, vorzugsweise aus Aluminium, eingesetzt, der an den Kanten des Routers 7 und der Grundplatte 2 zwischen den Halteblöcken 8 leicht übersteht. Dieser Kühlblock 9 ist auf seiner Ober- und seiner Unterseite mit je einer dünnen Polsterschicht (GapPad) 10 aus einem flexiblen, wärmeleitenden und elektrisch isolierenden Material, z.B. einer Silikongummimasse, versehen, die einerseits der Wärmeableitung dient und andererseits, indem sie Druck nachgeben kann, Unregelmäßigkeiten zwischen den Bauteilen und auch durch Wärmeausdehnung bedingte thermomechanische Kräfte an den umgebenden Materialien, teilweise ausgleichen kann. Am überstehenden Rand des Kühlblocks 9 sind Löcher vorgesehen, in denen mit Hilfe eines zweiten Satzes von Haltebolzen 11 als eine zweite elektronische Baueinheit 12 ein Modem 12 verankert werden kann, das auf einer Trägerplatte 13 angeordnet ist. Die Löcher im Kühlblock 9 korrespondieren dazu mit ebensolchen Löchern in der Trägerplatte 13. Das Modem 12 wird so platziert, dass es auf der oberen Polsterschicht (GapPad) 10 des Kühlblocks 9 zur Auflage kommt und seine Trägerplatte 13 nach oben weist. Sowohl der Router 7 als auch das Modem 12 befinden sich so über die jeweilige dünne, wärmeleitende, elektrisch isolierende Polsterschicht 10 (GapPad) in engem Kontakt mit dem Kühlblock 9. Alle Bauelemente werden von der Grundplatte 2 getragen; sie sind als Paket am von den Winkeln 3 der Grundplatte 2 abgewandten Rand der Grundplatte 2 leicht überstehend und etwa mittig platziert. Auf der nach oben weisenden Trägerplatte 13 des Modems 12 wird eine leicht V-förmig gebogene Blattfeder 14 angeordnet, die sich mit ihren V-Schenkeln auf der Trägerplatte 13 abstützt. Wenn das Gerät mit einem (nicht dargestellten) Deckel verschlossen wird, soll dieser in engen Kontakt mit der V-Spitze dieser Blattfeder 14 kommen und Druck auf sie ausüben; durch die Kraft der Feder 14 werden somit die Bauelemente auf der Grundplatte 2 in Position und in engem Kontakt miteinander gehalten (siehe dazu auch Fig. 2 und 3). Die Bauteile sind auf diese Weise thermomechanisch miteinander verbunden, und es findet ein Temperaturausgleich zwischen den Bauteilen statt.

Zur Positionierung und Halterung der Grundplatte 2 samt Aufbau im Gehäuse werden außerdem zwischen die Winkel 3 der Grundplatte 2 und die ihnen gegenüberstehende Gehäusewand leicht V-förmig gebogene und entsprechend dimensionierte Blattfedern 15 derart eingesetzt, dass sie sich mit ihrer V-Spitze an der inneren Gehäusewand und mit ihren Schenkeln an den Winkeln 3 der Grundplatte 2 abstützen und so mit ihrer Federkraft die Grundplatte 2 samt Aufbau wie einen Schlitten gegen die entgegengesetzte Gehäusewand schieben und drücken. Die Grundplatte 2 wird so allein durch die Kraft dieser Federn 15 in ihrer Position gehalten. Es ist kein Schrauben mehr nötig, und die Federn 15 können bei Temperaturschwankungen auftretende Wärmeausdehnungen und deren Rückbildung automatisch ausgleichen, so dass es nicht mehr zu durch Thermomechanik bedingte Schäden am und im Gerät kommt. Sollte eine Reparatur, ein Austausch von Baueinheiten im Gerät erforderlich werden, erleichtert die besondere Halterung der Grundplatte 2 durch Federn 15 die Entnahme und das Wiedereinsetzen von Bauteilen und Baugruppen.

Wird die Grundplatte 2 samt Aufbau von den Federn 15 gegen die gegenüberliegende Gehäusewand gedrückt, kommt der am Aufbau vorzugsweise leicht überstehende Kühlblock 9 in enge Berührung mit der inneren Gehäusewand. Eine weitere, an dieser Stelle vorgesehene, flexible, wärmeleitende und elektrisch isolierende Polsterschicht (GapPad) 16 aus einer Silikongummimasse, gegen die der Kühlblock 9 dann drückt, verbessert die Wärmeableitung zur Gehäusewand. An der Außenseite dieser Gehäusewand ist ein Kühlkörper 17, z.B. in Form von Kühlrippen 17, angeordnet. Dieser Kühlkörper 17 kann angeformt sein oder er kann über eine EPDM-Dichtung wasserdicht am Gehäuse montiert sein. Vom Kühlblock 9 aufgenommene Wärme wird so über eine mechanische Entkopplung, nämlich die flexible, wärmeleitende Polsterschicht (GapPad) 16 an die Gehäusewand und über den Kühlkörper 17 an die Außenluft abgegeben.

In dem geforderten Temperaturbereich von -40°C bis +70°C muss in einem Gerät nicht nur für Wärmeabfuhr und Kühlung sondern bei sehr niedrigen Temperaturen auch für Wärmezufuhr, also Heizung, gesorgt werden, um das Gerät funktionsfähig zu halten. An der Innenseite der Gehäusewand, gegen die die Grundplatte 2 samt Aufbau und vor allem der Kühlblock 9 drückt, ist dafür eine Heizfolie 18 angebracht, die temperaturabhängig ein- und ausgeschaltet werden kann. Dazu ist an der einen Schmalseite des Gerätes neben weiteren Anschlüssen eine Temperaturkontrolleinheit mit Temperaturfühler angeordnet. Abhängig von der gemessenen Temperatur kann bei hohen Temperaturen der Lüfter 5 und bei niedrigen Temperaturen die Heizfolie 18 aktiviert und aus derselben Energiequelle mit Strom gespeist werden. Bei aktivierter Heizfolie 18 wird der Kühlblock 9 (im Beispiel ein Aluminiumblock 9) mit den kritischen Bauteilen und auch der Innenraum des Gerätes aufgeheizt, um die Funktionsfähigkeit zu erhalten. Um der Bildung von Kondenswasser im Gerät entgegen zu wirken, kann in einer in der Gehäusewand vorgesehenen Öffnung ein sogenanntes und an sich bekanntes Gore Ventil 19, z.B. in Form eines Stopfens, vorgesehen werden. Es ist vorteilhaft, wenn sich dieses Gore Ventil 19 an einer Stelle geschützt hinter der Halterung 4 oder dem Halteblech 4 befindet.

Das so aufgebaute Gerät wird vorzugsweise nicht in herkömmlicher Weise flach liegend sondern aufrecht stehend bzw. in hochvertikaler Position eingesetzt. Das bietet den Vorteil, dass aufsteigende und vom Lüfter 5 nach oben getragene Wärme sich unter der oberen Schmalseite des Gehäuses staut und nicht flächig über den elektronischen Baueinheiten unter einem Deckel, so dass die Wärme eher von den elektronischen Baueinheiten weg nach oben zieht und diese der Wärme weniger ausgesetzt sind oder bleiben. Verstärkt wird dieser Effekt noch, wenn sich die elektronischen Baueinheiten, wie oben erwähnt, auf der Grundplatte 2 seitlich in der Mitte befinden und so einen größeren Abstand zur oberen, schmalen Gehäusewand halten als etwa zur Fläche eines Deckels. In dieser aufrecht stehenden Position beansprucht das Gerät vorteilhaft auch eine geringere Montagefläche. An der oberen Schmalseite des Gerätes, eben dort wo sich die Wärme staut und sich ein Anstieg der Temperatur zuerst bemerkbar macht, wird dann auch bevorzugt die Temperaturkontrolleinheit mit Temperaturfühler angebracht.

Um das Gerät wasserdicht und unempfindlich gegen Salzsprühnebel und Korrosion zu machen, wird zwischen der Gehäusewand und einem Deckel eine spezielle EPDM-Dichtung eingesetzt, die mit einer Nut versehen ist, um den Anpressdruck /mm² möglichst hoch zu halten und die Kriterien zur Prüfung auf Wasserdichtigkeit nach EN 60950 zu erfüllen. Um den EMV-Sicherheitsvorschriften zu entsprechen, werden die durch Dichtungen gegeneinander isolierten Teile, nämlich Basisgehäuseteil 1, (nicht dargestellter) Deckel und äußerer Kühlkörper 17 untereinander mit einem Litzendraht verbunden.

### Bezugszeichenliste:

- 1: Gehäuse
- 2: Grundplatte
- 3: Winkel
- 4: Halterung
- 5: Lüfter
- 6: Haltebolzen, erster Satz
- 7: erste elektronische Baueinheit, Router
- 8: Halteblöcke
- 9: Kühlblock
- 10: Polsterschichten (GapPads)
- 11: Haltebolzen, zweiter Satz
- 12: zweite elektronische Baueinheit, Modem
- 13: Trägerplatte (Modem)
- 14: Blattfeder
- 15: Blattfedern
- 16: Polsterschicht (GapPad)
- 17: Kühlkörper, Kühlrippen
- 18: Heizfolie
- 19: Gore Ventil

## Patentansprüche

1. Geräteaufbau, bei dem ein Gehäuse mehrere elektronische Bauelemente, Bausätze, Baueinheiten mit ihren Trägerplatten geschichtet aufnimmt und im oder am Gehäuse ein Lüfter vorgesehen ist, mit dessen Hilfe Luft zur Kühlung der Bauelemente durch das Gehäuse leitbar ist, und bei dem zwischen jeweils zwei elektronischen Baueinheiten ein Kühlblock aus wärmeleitendem Material vorgesehen ist, **dadurch gekennzeichnet, dass** die elektronischen Bauelemente, Bausätze, Baueinheiten mit ihren Trägerplatten und weitere Zusatzbauelemente auf einer im Gehäuse (1) verschiebbaren Grundplatte (2) geschichtet angeordnet sind, und dass die Grundplatte (2) allein durch die Kraft von Federn (15) im Gehäuse (1) so positionierbar und in Position haltbar ist, dass der geschichtete Aufbau ganz oder teilweise in Berührung steht mit der Innenseite einer benachbarten Gehäusewand.

2. Geräteaufbau nach Anspruch 1, **dadurch gekennzeichnet, dass** auf der Grundplatte (2) eine erste elektronische Baueinheit (Router) (7) mit ihrer Trägerplatte lösbar befestigt ist, der Kühlblock (9) auf einem dafür vorgesehenen Feld der ersten elektronischen Baueinheit (7) aufgesetzt und gehalten ist und die nächste (zweite) elektronische Baueinheit (Modem) (12), mit ihrer Trägerplatte (13) vom Kühlblock (9) wegweisend, auf dem Kühlblock (9) aufliegend an diesem lösbar befestigt ist und die Elemente dieses Aufbaus durch die Kraft einer V-förmig gebogenen Blattfeder (14), die sich mit ihren Schenkeln auf der Trägerplatte (13) der obersten elektronischen Baueinheit abstützt und durch einen das Gerät verschließenden Deckel gespannt wird, indem dieser Druck ausübend mit der Spitze der Feder (14) in Berührung kommt, als Paket zusammen gehalten werden.

3. Geräteaufbau nach Anspruch 1 oder 2, **dadurch gekennzeichnet, dass** der Kühlblock (9) aus Aluminium besteht und auf seiner Ober- und seiner Unterseite jeweils mit einer Polsterschicht (GapPad) (10) aus einem flexiblen, wärmeleitfähigen und elektrisch isolierenden Material versehen ist und diese Polsterschichten (GapPads) (10) die Auflageflächen für die elektronischen Baueinheiten (7, 12) bilden.

4. Geräteaufbau nach Anspruch 2, **dadurch gekennzeichnet, dass** die erste elektronische Baueinheit (Router) (7) an der Grundplatte (2) und die zweite elektronische Baueinheit (Modem) (12) am Kühlblock (9) mittels steckbarer Haltebolzen (6, 11) lösbar befestigt sind.

5. Geräteaufbau nach Anspruch 1, **dadurch gekennzeichnet, dass** der geschichtete Aufbau an der einen Längskante der Grundplatte (2) übersteht und hier in Berührung kommt mit der Innenseite der benachbarten Gehäusewand.

6. Geräteaufbau nach Anspruch 1, **dadurch gekennzeichnet, dass** der Kühlblock (9) an der einen Längskante der Grundplatte (2) übersteht und in Berührung kommt mit der Innenseite der benachbarten Gehäusewand.

7. Geräteaufbau nach Anspruch 5 oder 6, **dadurch gekennzeichnet, dass** an der Stelle, wo der geschichtete Aufbau oder der Kühlblock (9) in Berührung steht mit der Innenseite der benachbarten Gehäusewand, an dieser eine Polsterschicht (GapPad) (16) aus flexiblem, wärmeleitfähigem, elektrisch isolierendem Material vorgesehen ist.

8. Geräteaufbau nach Anspruch 1, **dadurch gekennzeichnet, dass** der geschichtete Aufbau an der einen Längskante der Grundplatte (2) mittig angeordnet ist.

9. Geräteaufbau nach Anspruch 1, **dadurch gekennzeichnet, dass** an der Außenseite der Gehäusewand, mit deren Innenseite der geschichtete Aufbau oder der Kühlblock (9) in Berührung steht, ein äußerer Kühlkörper (17) vorgesehen ist.

10. Geräteaufbau nach Anspruch 1, **dadurch gekennzeichnet, dass** an der dem geschichteten Aufbau abgewandten Kante der Grundplatte (2) Winkel (3) angeordnet sind, die der dem geschichteten Aufbau abgewandten Gehäusewand gegenüberstehen, und dass durch die Kraft von V-förmig gebogenen Blattfedern (15), die sich einerseits an dieser Gehäusewand und andererseits an den Winkeln (3) abstützen, die Grundplatte (2) samt Aufbau im Gehäuse (1) derart positioniert und in Position gehalten wird, dass der geschichtete Aufbau in Berührung steht mit der ihm benachbarten Gehäusewand.

11. Geräteaufbau nach Anspruch 1, **dadurch gekennzeichnet, dass** an der Innenseite der Gehäusewand, mit der der geschichtete Aufbau in Berührung steht, eine Heizfolie (18) vorgesehen ist und dass die Heizfolie (18) und der Lüfter (5) über eine Temperaturkontrolleinheit mit Temperaturfühler temperaturabhängig gesteuert ein- und ausschaltbar sind.

12. Geräteaufbau nach einem der vorangehenden Ansprüche, **dadurch gekennzeichnet, dass** die Betriebsposition des Gerätes hochvertikal stehend ist und an der oberen Schmalseite des Gehäuses eine Temperaturkontrolleinheit mit Temperaturfühler angeordnet ist.

## Claims

1. Device structure in which a housing accommodates a plurality of electronic components, construction sets, structural units with their carrier plates in a layered fashion and in which a fan is provided in or on the housing, with the aid of which fan air can be conducted through the housing in order to cool the components, and in which a cooling block made of thermally conductive material is provided between two electronic structural units in each case, **characterized in that** the electronic components, construction sets, structural units with their carrier plates and further additional components are arranged in a layered fashion on a base plate (2) which can be displaced in the housing (1), and **in that** the base plate (2) alone can be positioned by the force of springs (15) in the housing (1) and secured in position in such a way that the layered structure is entirely or partially in contact with the inside of an adjacent housing wall.

2. Device structure according to Claim 1, **characterized in that** a first electronic structural unit (router) (7) with its carrier plate is detachably fastened to the base plate (2), the cooling block (9) is fitted on a field, provided for that purpose, of the first electronic structural unit (7) and secured, and the next (second) electronic structural unit (modem) (12) is detachably fastened to the cooling block (9) in such a way that it rests thereon and points with its carrier plate (13) from cooling block (9), and the elements of this structure are secured together as a packet by the force of a leaf spring (14) which is bent in a V shape, is supported with its limbs on the carrier plate (13) of the uppermost electronic structural unit and is clamped by a lid which closes the device, said clamping occurring by virtue of the fact that said lid applies pressure as it comes into contact with the tip of the spring (14).

3. Device structure according to Claim 1 or 2, **characterized in that** the cooling block (9) is composed of aluminium and is provided on its upper side and its underside with, in each case, an upholstered layer (GapPad) (10) made of a flexible, thermally conductive and electronic insulating material, and these upholstered layers (GapPads) (10) form the support surfaces for the electronic structural units (7, 12).

4. Device structure according to Claim 2, **characterized in that** the first electronic structural unit (router) (7) is detachably fastened to the base plate (2), and the second electronic structural unit (modem) (12) is detachably fastened to the cooling block (9) by means of pluggable securing bolts (6, 11).

5. Device structure according to Claim 1, **characterized in that** the layered structure protrudes on the one longitudinal side of the base plate (2) and comes into contact here with the inside of the adjacent housing wall.

6. Device structure according to Claim 1, **characterized in that** the cooling block (9) protrudes on the one longitudinal side of the base plate (2) and comes into contact with the inside of the adjacent housing wall.

7. Device structure according to Claim 5 or 6, **characterized in that** at the location where the layered structure or the cooling block (9) comes into contact with the inside of the adjacent housing wall an upholstered layer (GapPad) (16) made of a flexible, thermally conductive electrically insulating material is provided on said housing wall.

8. Device structure according to Claim 1, **characterized in that** the layered structure is arranged centrally on the one longitudinal side of the base plate (2).

9. Device structure according to Claim 1, **characterized in that** an external heat sink (17) is provided on the outside of the housing wall, with the inside of which the layered structure or the cooling block (9) is in contact.

10. Device structure according to Claim 1, **characterized in that** brackets (3), which lie opposite the housing wall which faces away from the layered structure, are arranged on the edge of the base plate (2) which faces away from the layered structure, and **in that** as a result of the force of leaf springs (15) which are bent in a V shape and which are supported both on this housing wall and on the brackets (3), the base plate (2) together with the structure is positioned in the housing (1) and secured in position in such a way that the layered structure comes into contact with the housing wall which is adjacent to it.

11. Device structure according to Claim 1, **characterized in that** a heating film (18) is provided on the inside of the housing wall with which the layered structure is in contact, and **in that** the heating film (18) and the fan (5) can be switched on and off in a controlled fashion as a function of the temperature by means of a temperature control unit with a temperature sensor.

12. Device structure according to one of the preceding claims, **characterized in that** the operating position of the device is completely vertical, and a temperature control unit with a temperature sensor is arranged on the upper narrow side of the housing.

## Revendications

1. Montage d'appareil, dans lequel un boîtier reçoit de manière empilée plusieurs composants électroniques, ensembles modulaires et unités structurelles avec leurs plaques support, dans lequel un ventilateur est prévu dans ou sur le boîtier, à l'aide duquel de l'air peut être guidé à travers le boîtier pour refroidir les composants, et dans lequel un bloc de refroidissement en matériau thermoconducteur est prévu à chaque fois entre deux unités structurelles électroniques, **caractérisé en ce que** les composants électroniques, ensembles modulaires, unités structurelles avec leurs plaques support, ainsi que d'autres composants supplémentaires sont disposés de manière empilée sur une plaque de base (2) déplaçable dans le boîtier (1), et **en ce que** la plaque de base (2) peut être positionnée et maintenue en position simplement par la force de ressorts (15) dans le boîtier (1), de telle sorte que le montage empilé soit complètement ou partiellement en contact avec le côté intérieur d'une paroi de boîtier adjacente.

2. Montage d'appareil selon la revendication 1, **caractérisé en ce qu'**une première unité structurelle électronique (routeur) (7) est fixée avec sa plaque support de manière amovible sur la plaque de base (2), le bloc de refroidissement (9) est posé et maintenu sur un champ prévu à cet effet de la première unité structurelle électronique (7) et l'unité structurelle électronique suivante (la deuxième) (modem) (12), dont la plaque support (13) est tournée à l'écart du bloc de refroidissement (9), est fixée de manière amovible au bloc de refroidissement (9) à plat sur celui-ci, et les éléments de ce montage sont maintenus ensemble sous forme de paquet par la force d'un ressort à lame (14) cintré en forme de V, qui s'appuie avec ses branches sur la plaque support (13) de l'unité structurelle électronique supérieure, et qui est tendu par un couvercle fermant l'appareil, celui-ci venant en contact avec la pointe du ressort (14) en exerçant une pression.

3. Montage d'appareil selon la revendication 1 ou 2, **caractérisé en ce que** le bloc de refroidissement (9) se compose d'aluminium et est pourvu, sur son côté supérieur et sur son côté inférieur à chaque fois d'une couche de rembourrage (GapPad) (10) en un matériau flexible, thermoconducteur et électriquement isolant, et ces couches de rembourrage (GapPads) (10) constituent les faces d'appui pour les unités structurelles électroniques (7, 12).

4. Montage d'appareil selon la revendication 2, **caractérisé en ce que** la première unité structurelle électronique (routeur) (7) est fixée de manière amovible à la plaque de base (2) et la deuxième unité structurelle électronique (modem) (12) est fixée de manière amovible au bloc de refroidissement (9) au moyen de boulons de retenue enfichables (6, 11).

5. Montage d'appareil selon la revendication 1, **caractérisé en ce que** le montage empilé dépasse au niveau d'une arête longitudinale de la plaque de base (2) et vient en contact à cet endroit avec le côté intérieur de la paroi de boîtier adjacente.

6. Montage d'appareil selon la revendication 1, **caractérisé en ce que** le bloc de refroidissement (9) dépasse au niveau d'une arête longitudinale de la plaque de base (2) et vient en contact avec le côté intérieur de la paroi de boîtier adjacente.

7. Montage d'appareil selon la revendication 5 ou 6, **caractérisé en ce qu'**à l'endroit où le montage empilé ou le bloc de refroidissement (9) est en contact avec le côté intérieur de la paroi de boîtier adjacente, on prévoit sur celle-ci une couche de rembourrage (GapPad) (16) en matériau flexible, thermoconducteur et électriquement isolant.

8. Montage d'appareil selon la revendication 1, **caractérisé en ce que** le montage empilé est disposé centralement sur l'une des arêtes longitudinales de la plaque de base (2).

9. Montage d'appareil selon la revendication 1, **caractérisé en ce qu'**un corps de refroidissement extérieur (17) est prévu sur le côté extérieur de la paroi de boîtier avec le côté intérieur de laquelle vient en contact le montage empilé ou le bloc de refroidissement (9).

10. Montage d'appareil selon la revendication 1, **caractérisé en ce que** des coudes (3) sont disposés sur l'arête de la plaque de base (2) opposée au montage empilé, lesquels coudes sont en regard de la paroi de boîtier opposée au montage empilé, et **en ce que** du fait de la force de ressorts à lame cintrés en forme de V (15), qui s'appuient d'une part à cette paroi de boîtier et d'autre part aux coudes (3), la plaque de base (2) ainsi que le montage sont positionnés et maintenus en position dans le boîtier (1) de telle sorte que le montage empilé soit en contact avec la paroi de boîtier qui lui est adjacente.

11. Montage d'appareil selon la revendication 1, **caractérisé en ce qu'**un film chauffant (18) est prévu sur le côté intérieur de la paroi de boîtier avec laquelle le montage empilé est en contact, et **en ce que** le film chauffant (18) et le ventilateur (5) peuvent être connectés et déconnectés de manière commandée en fonction de la température par le biais d'une unité de contrôle de température avec des palpeurs de température.

12. Montage d'appareil selon l'une quelconque des revendications précédentes, **caractérisé en ce que** la position de fonctionnement de l'appareil est debout verticalement et une unité de contrôle de température avec des palpeurs de température est disposée sur le côté supérieur étroit du boîtier.
